# EUROPÄISCHE PATENTSCHRIFT

(11) **EP 1 030 185 B1**
(45) Veröffentlichungstag und Bekanntmachung des Hinweises auf die Patenterteilung: **27.11.2002**
(21) Anmeldenummer: 00102877.8
(22) Anmeldetag: 11.02.2000
(51) Int. Cl.: G01R 31/02, G01R 31/00

(54) **Einrichtung zur Stromüberwachung in einem Stromversorgungssystem**
Means for monitoring the current in a power distribution network
Dispositif pour controler le courant dans un réseau de distribution d'énergie

(30) Priorität: 15.02.1999 DE 19906276
(43) Veröffentlichungstag der Anmeldung: 23.08.2000
(60) Teilanmeldung: 02013516.6
(73) Patentinhaber: Isabellenhütte Heusler GmbH KG, D-35683 Dillenburg (DE)
(72) Erfinder: Hetzler, Ullrich, Dr., 35688 Dillenburg-Oberscheld (DE)
(74) Vertreter: Heusler, Wolfgang, Dipl.-Ing.

(56) Entgegenhaltungen:
- EP-A- 0 408 867
- DE-A- 3 942 165
- DE-A- 19 510 662
- DE-C- 19 507 959
- US-A- 4 942 571

## Beschreibung

Die Erfindung betrifft eine Einrichtung zur Stromüberwachung in einem Stromversorgungssystem gemäß dem Oberbegriff des Anspruchs 1.

Ein typisches Beispiel für ein Stromversorgungssystem der hier betrachteten Art ist die Versorgung der mit zunehmenden Anforderungen an Komfort, Sicherheit und Umweltverträglichkeit von Jahr zu Jahr wachsenden Anzahl elektrischer Verbraucher in Kraftfahrzeugen. Für den entsprechend erhöhten Stromverbrauch erweist es sich als zweckmäßig, die verschiedenen Verbraucher ring- oder sternförmig über einen gemeinsamen Leistungsbus an eine Quelle relativ hoher Spannung von beispielsweise 42V anzuschließen, die niedrigere Ströme als bei den bisher üblichen 12V-Batterien und entsprechend kleinen Leitungsquerschnitt ermöglicht. Wenn man beispielsweise einen Gesamtverbrauch von bis zu 5 kW annimmt, ergibt sich bei 42V ein maximaler Gesamtstrom von 120 A, der in Fahrzeugen noch gut zu beherrschen ist. Die Quelle hoher Spannung kann zusätzlich zu einem Bordnetz niedrigerer Spannung vorgesehen sein.

Für den Steuer- und Informationsdatenaustausch zwischen den ebenfalls immer zahlreicher werdenden verschiedenen Prozessoren, Aktoren und Sensoren von Fahrzeugen u.a. für Motorsteuerung und Komfort-Elektronik (Fensterheber, automatische Sitzverstellung, Klimaregelung usw.) hat sich bereits weitgehend die Verwendung von genormten Datenbussystemen (beispielsweise des sogenannten CAN-Bus) durchgesetzt, die parallel zu dem Leistungsbus angeordnet werden können. Auch für die benötigten Halbleiter ist ein Stromversorgungsnetz mit höheren Spannungen wie z.B. 42V vorteilhaft, da aus verschiedenen Gründen die für das sichere Schalten eines Verbrauchers benötigte Halbleiterfläche wesentlich geringer ist als im Falle eines 12V-Bordnetzes.

Mit zunehmender Anzahl der Verbraucher und steigender Gesamtleistung wächst aber andererseits die Gefahr von Störungen und insbesondere von Kurzschlüssen, deren Folgen katastrophal für Sicherheit und Funktion des Fahrzeugs sein können. Besonders groß ist die Brandgefahr. Entsprechend groß war bisher der erforderliche Sicherheits- und Funktionsprüfaufwand unter Verwendung von Sicherungen und Strommeßelementen, die typisch den einzelnen Verbrauchern individuell zugeordnet wurden.

Aus der DE 195 07 959 C ist eine Vorrichtung zur Strommessung an einer der Hauptstromleitungen einer Fahrzeugbatterie bekannt, bei der ein Spannungsabfall an einem Meßwiderstand in der zu messenden Hauptstromleitung von einem externen Prüfgerät erfasst und ausgewertet wird. Das externe Prüfgerät vergleicht den bei Aktivierung der einzelnen Verbraucher gemessenen Batteriestrom mit gespeicherten Sollwerten. Als Meßwiderstand dient ein über eine zusätzliche Prüfleitung kalibrierter Abschnitt der Hauptstromleitung, wodurch sich die Notwendigkeit erübrigen soll, einen Präzisionsmeßwiderstand einzusetzen.

Auch aus der EP 0408867 A ist ein externes Testsystem für die Verbraucher eines Kraftfahrzeugs bekannt, bei dem nach Aktivierung des jeweils zu testenden Verbrauchers dessen Strom in der externen Diagnoseeinheit mit einem verbraucherspezifischen Sollwert verglichen wird. Als Meßwiderstand wird hierbei ein externer Shunt zwischen die Fahrzeugbatterie und den Verbraucher geschaltet.

Die DE 39 42 165 A beschreibt ein System zur Stromüberwachung in einem Kraftfahrzeug, bei dem mehrere parallel zueinander an einen von der Batterie gespeisten Leistungsbus angeschlossene Stellelemente mit Strom versorgt werden. Zwischen den Leistungsbus und jedes Stellelement ist ein magnetischer Stromsensor geschaltet, mit dem der in die jeweilige Betriebsschaltung der Stellelemente fließende Strom erfasst wird. Bei der Feststellung von Fehlern wird zur Ausschaltung von Meßfehlern aufgrund der Offsetspannung des magnetischen Sensors der in die Betriebsschaltung fließende Strom zunächst vor Anlegen eines Steuersignals zur Betätigung des betreffenden Stellelementes erfaßt und dann nach einer vorbestimmten Zeit nach Anlegen dieses Steuersignals nochmals gemessen. Aus der Differenz der gemessenen Stromwerte kann dann ermittelt werden, ob ein Funktionsfehler des entsprechenden Stellgliedes vorliegt.

Die US 4,942,571 beschreibt ein in ein Kraftfahrzeug eingebautes Multiplex-Überwachungssystem, bei dem ebenfalls jedem Verbraucher eigene Sensoren zugeordnet sind.

Aus der DE 19510662 A ist ein aktives optisches Strommeßsystem für die isolierte Strommessung in Hochspannungsstromrichtern bekannt, bei dem die Sensorelektronik in einem Hohlraum im Inneren eines zweiteiligen Präzisionsmesswiderstands untergebracht und ausgangsseitig mit einem Lichtwellenleiteranschluss verknüpft ist. Diese Anordnung dient dem mechanischen Schutz und der elektromagnetischen Abschirmung der Sensorelektronik.

Der Erfindung liegt die Aufgabe zugrunde, eine Stromüberwachungseinrichtung anzugeben, die auf einfache Weise mit geringerem Aufwand als bisher eine schnelle und möglichst genaue Stromüberwachung im Stromversorgungssystem beispielsweise eines Fahrzeugs mit zahlreichen Verbrauchern ermöglicht.

Diese Aufgabe wird durch die Patentansprüche gelöst.

Gemäß einem Vorteilhaften Anwendungsbeispiel der Erfindung wird nicht jedem Verbraucher ein eigener Stromsensor zugeordnet, sondern mehreren oder sogar allen Verbrauchern ein einziger Präzisionsmeßwiderstand in dem Leistungsbus zur permanenten Stromüberwachung vorgeschaltet. Die Stromerfassung ist schnell und genau und kann über den Steuerbus dem Zu- oder Abschalten eines Verbrauchers zeitlich exakt zugeordnet werden. Da der jeweilige Strom-Istwert über den Steuerbus jedem vorhandenen Prozessor oder sonstigen Steuerglied direkt zugänglich ist, kann das elektronische Steuer- und Überwachungssystem problemlos feststellen, ob sich bei dem betreffenden Schaltvorgang normale Stromänderungen ergeben oder nicht. Beispielsweise läßt sich über den Stromverbrauch von Aktoren deren Belastung feststellen und damit Fehl- oder Störfunktionen der betreffenden Motoren (Fensterheber, Anlasser, Lüfter u.a.) erkennen. Insbesondere die permanente Erfassung des Gesamtstroms im Fahrzeug kann zum Erkennen von Störfällen von großer. Bedeutung sein. Auch der Strom eines den Leistungsbus speisenden Generators kann überwacht werden.

Da viele oder alle Verbraucher und ggf. der Generator mit einem einzigen Stromsensorwiderstand überwacht werden können, besteht die Möglichkeit, auf zahlreiche bisher notwendige Stromsensoren und Sicherheitsschaltungen wie z.B. individuelle Lampenstromerfassung, Sicherungen usw. zu verzichten. Darüber hinaus werden ganz neue Möglichkeiten der Sicherheits- und Funktionsprüfung eröffnet. Aus der Auswertung der gemessenen Stromdifferenz kann die Steuerung auch sonstige Schaltsignale für beliebige Steuervorgänge erzeugen, beispielsweise zum Abschalten einzelner nicht dringend benötigter Verbraucher wie etwa der Heckscheibenheizung bei zu hohem Gesamtstrom.

Die Anordnung des Präzisionsmeßwiderstands in dem Leistungsbus ermöglicht auch auf einfache Weise eine Stromsteuerung zum Schutz der den Bus und die angeschlossenen Verbraucher speisenden Batterie, insbesondere mit dem Ziel der Verlängerung ihrer Lebensdauer. Mit der Messung des durch den Bus fließenden Gesamtstroms kann man nämlich auch die Lade- und Entladeströme der Batterie überwachen und begrenzen.

Welche Überwachung im einzelnen in einem Fahrzeug vorgenommen wird, ist im wesentlichen eine Frage des vorhandenen Steuersystems und der zugehörigen Software. Die Ausführung des den Präsionsmeßwiderstand enthaltenden Stromsensors könnte aber für alle Anwendungen identisch sein.

Der bauliche Steueraufwand kann dadurch auf ein Minimum reduziert werden, daß entsprechend der heutigen Halbleitertechnik in einem einzigen kleinen, preisgünstig herstellbaren Halbleiterchip als anwendungsspezifische integrierte Schaltung (ASIC) eine komplette Steuereinheit für den Steuerbus zusammen mit den zum Meßwiderstand gehörenden Schaltungen wie Meßverstärker, A/D-Wandler, Prozessor, Speichern usw. untergebracht werden können.

Für die gewünschte schnelle und möglichst extrem genaue Stromerfassung sind von entscheidender Wichtigkeit einerseits die Meßpräzision des verwendeten Meßwiderstands selbst und andererseits die störungsfreie Übertragung der Meßspannung des Widerstands in das Steuersystem. Hierbei kommt es neben der Vermeidung externer Störsignale vor allem auf die Unabhängigkeit von Temperatureinflüssen an.

Diese Probleme werden durch den Anspruch 1 gelöst. Neben kleinem Bauvolumen und einfacher. kostengünstiger Herstellbarkeit hat dieses Strommeßmodul den Vorteil extrem kurzer Verbindungen zwischen den Spannungsanschlüssen des Meßwiderstands und den zugehörigen Halbleiterschaltungen mit der Folge, daß keine wesentlichen Störspannungen induziert werden können. Darüber hinaus ergeben sich aufgrund der thermischen Kopplung optimale Temperaturkompensationsmöglichkeiten. Bei dem Widerstand kann es sich zweckmäßig um ein Bauelement mit einem aus einer Widerstandslegierung bestehenden plattenförmigen Widerstandselement handeln, an dessen Kanten in an sich bekannter Weise (EP 0 605 800 B1) plattenförmige Anschlußteile angeschweißt sind. Der Widerstand läßt sich mit sehr kleinem Widerstandswert herstellen, beispielsweise in der Größenordnung von 0,1-0,5 mOhm, was entsprechend kleine Verlustleistung selbst bei erheblichen Stromstärken bedeutet, die im Falle von Fahrzeugen kurzzeitig bis 500 A betragen können.

Strommeßmodule der hier beschriebenen Bauform können sowohl zur Erfassung des Gesamtstroms mehrerer oder aller Verbraucher des Systems eingesetzt als auch zur individuellen Strommessung nur in den Stromkreis einzelner Verbraucher oder einzelner Gruppen von (z.B. 2) Verbrauchern geschaltet werden.

Am Beispiel des Stromversorgungssystems eines Kraftfahrzeuges soll die Erfindung näher erläutert werden. In der Zeichnung zeigen
- Fig. 1: den prinzipiellen Aufbau des Steuer- und Leistungsbussystems mit einem Stromsensor;
- Fig. 2: verschiedene Möglichkeiten für die Anordnung von Stromsensoren zur Überwachung von Bestandteilen des Stromversorgungssystems;
- Fig. 3: verschiedene Ansichten eines für das System nach Fig. 1 geeigneten Strommeßmoduls gemäß einer ersten Ausführungsform; und
- Fig. 4: Ansichten einer anderen Ausführungsform des Strommeßmoduls.

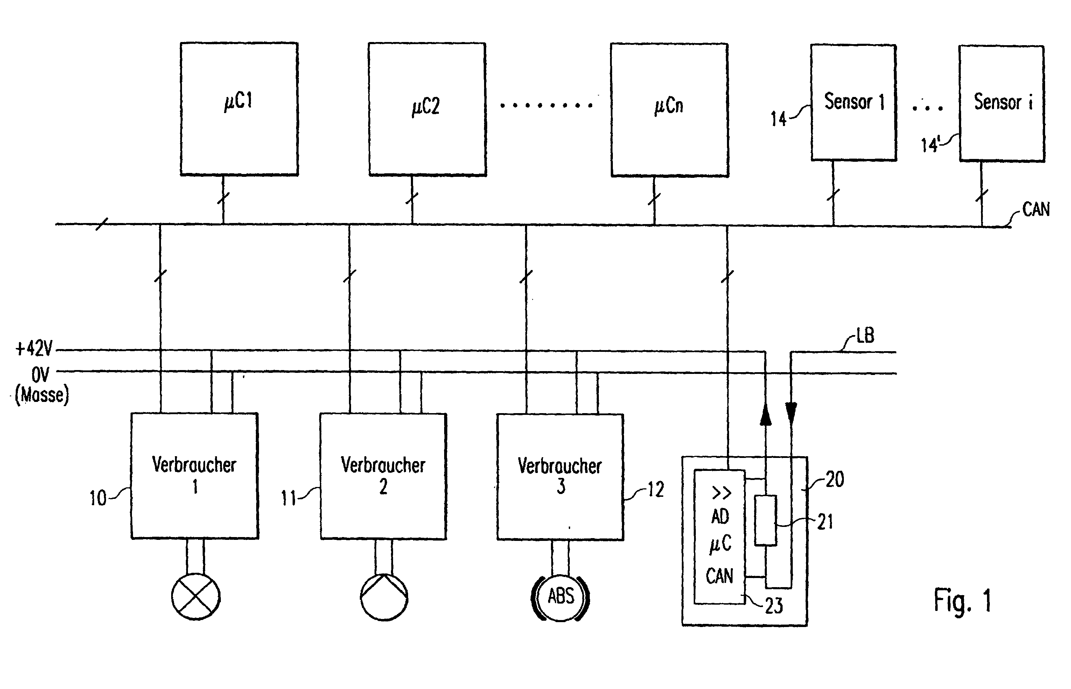

Gemäß Fig. 1 sind über einen Leistungsbus LB hintereinander drei Verbraucher 10, 11 bzw. 12 wie beispielsweise eine Glühlampe, eine Wasserpumpe bzw. ein ABS-Bremssystem mit jeweils zugehörigen Schalteinheiten an einen Stromgenerator (nicht dargestellt) angeschlossen, dessen Spannung beispielsweise 42V betragen kann. Die Schalteinheiten der Verbraucher 10 bis 12 sind ferner über Datenleitungen an einen gemeinsamen Steuerbus CAN angeschlossen, der in bekannter Weise eine Vielzahl von Mikrocontrollern (Mikroprozessoren für spezielle Steueraufgaben) µC1, µC2..µCn beispielsweise für Motormanagement, Komfortelektronik, Temperaturregelung usw. und/oder zur Steuerung der genannten Verbraucher sowie Sensoren 14, 14' etwa für Kühlwassertemperatur, Motordrehzahl usw. miteinander verbindet.

Zur Stromüberwachung der dargestellten Verbraucher 10, 11 und 12 dient ein einziges Strommeßmodul 20, das im wesentlichen aus einem mit zwei Stromanschlüssen und zwei gesonderten Spannungsanschlüssen versehenen Präzisionsmeßwiderstand 21 und einem an die Spannungsanschlüsse angeschlossenen Halbleiterchip 23 besteht. Der Präzisionsmeßwiderstand 21 ist über seine Stromanschlüsse darstellungsgemäß elektrisch in Reihe in den Leistungsbus geschaltet, und zwar zwischen den 42V-Stromgenerator und die Verbraucher 10 bis 13, so daß deren jeweiliger Gesamtstrom durch den Präzisionsmeßwiderstand 21 fließt. Das Halbleiterchip 23 kann einen Meßverstärker, einen A/D-Wandler und einen Mikrocontroller sowie Datenspeicher enthalten und mit einem Stecker des Strommeßmoduls 20 zum Anschluß an den Steuerbus CAN verbunden sein.

Wie schon erwähnt wurde, ist der Steuerbus CAN ein genormtes System, das digitale Informations- und Steuerdaten in definierter "Sprache" oder Codierung zwischen den angeschlossenen Sensoren, Prozessoren und Aktoren überträgt. Wenn einer der Verbraucher 10 bis 12 eingeschaltet werden soll, ruft die elektronische Steuerung des Systems, also beispielsweise einer der Mikrocontroller zunächst über den Steuerbus CAN aus dem Strommeßmodul 20 den aktuellen Strommeßwert ab und speichert ihn. Dann erfolgt die Umschaltung, und nach einer vorbestimmten kurzen Wartezeit ruft die Steuerung den sich nach dem Schaltvorgang ergebenden neuen Strommeßwert ab. Die gemessene Stromdifferenz kann nun mit einem gespeicherten Sollwert oder Sollwertbereich verglichen werden, und bei unnormaler Abweichung kann ein Warnsignal erzeugt oder, falls aus Sicherheitsgründen erforderlich, auch der Strom abgeschaltet werden.

Generell kann es zweckmäßig sein, den Wert des kontinuierlich gemessenen Stroms über den Steuerbus CAN permanent möglichst vielen Controllern oder Prozessoren des Steuersystems zur Verfügung zu stellen. Die Auswertung dieser Strommessung und daraus resultierende Schaltmaßnahmen bleiben dem jeweiligen Einzelfall überlassen.

Es ist auch denkbar, die Auswertung der Strommessung in dem eigenen Halbleiterchip 23 des Strommeßmoduls 20 durchzuführen und nur die ggf. resultierenden Schaltsteuersignale dem Steuerbus CAN oder einem sonstigen Steuerssystem zuzuführen.

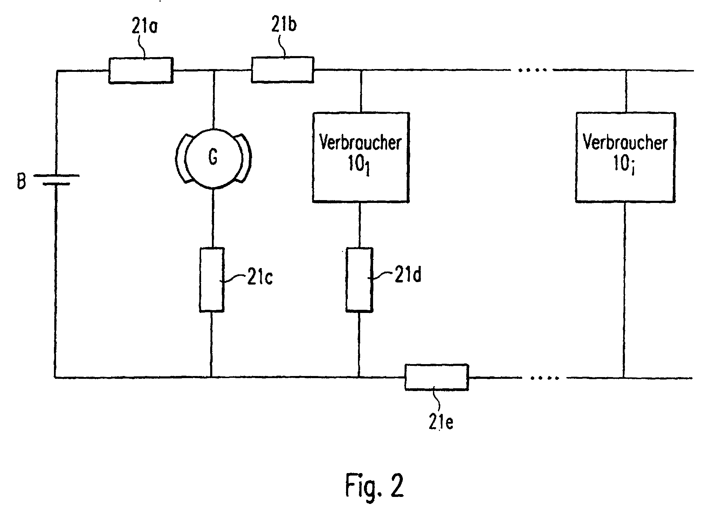

Während in Fig. 1 nur ein einziges Strommeßmodul 20 vorgesehen ist, kann es in vielen Fällen zweckmäßig sein, je ein solches Modul an verschiedenen Stellen des Stromversorgungssystems in das Leistungsbussystem einzusetzen. Einige Möglichkeiten hierfür sind in Fig. 2 dargestellt, in der eine Batterie B, ein Generator G (der auch als Anlassermotor dienen kann), beliebige Verbraucher 10₁...10ᵢ und fünf an verschiedenen Stellen angeordnete Meßwiderstände 21a bis 21e dargestellt sind. Darstellungsgemäß mißt der Widerstand 21a den Batteriestrom, der Widerstand 21b den Gesamtverbraucherstrom, der Widerstand 21c den Generatorstrom, der Widerstand 21d den individuellen Strom des Verbrauchers 10₁ und der Widerstand 21e den Strom einer restlichen Gruppe von Verbrauchern.

Wie eingangs schon erwähnt wurde, können mit einem in den Leistungsbus geschalteten Widerstand wie z. B. 21a die Lade- und Entladeströme der Batterie überwacht und die über den zugehörigen Steuerbus (in Fig. 2 nicht dargestellt) übertragenen entsprechenden Meßsignale bzw. daraus gewonnene Steuerdaten dazu verwendet werden, den Strom auf einen für die Batterie zulässigen Maximalwert zu begrenzen. Eine ähnliche Möglichkeit besteht darin, mit aus den Meßsignalen gewonnenen Steuerdaten ein Überladen oder zu starken Entladen der Batterie zu verhindern.

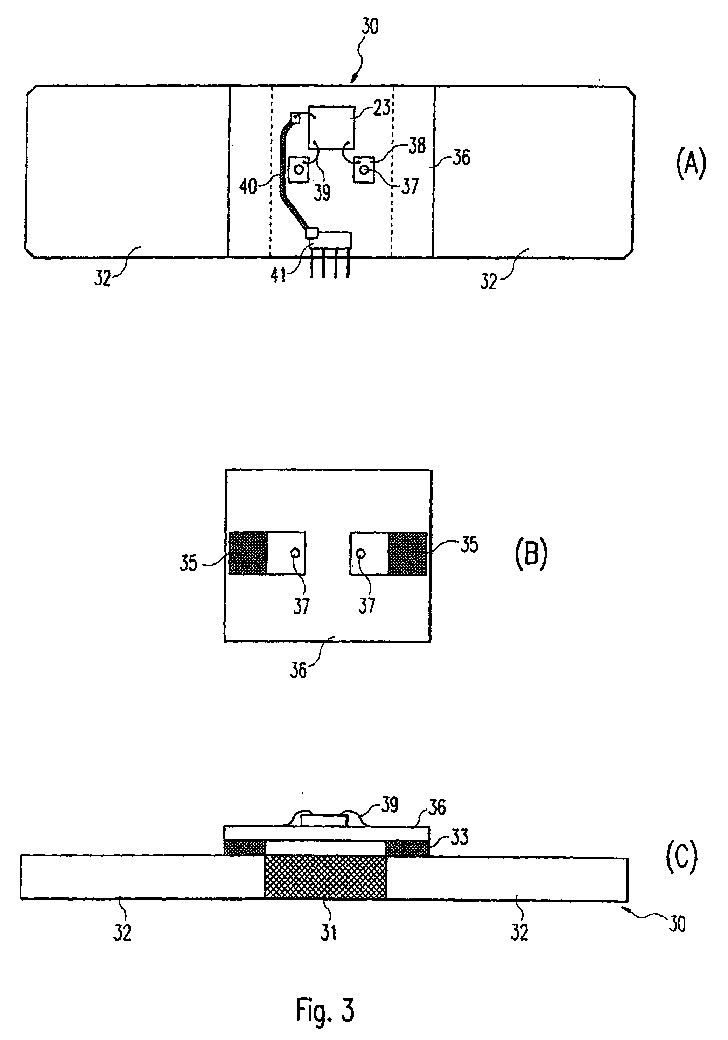

Eine erste zweckmäßige Bauform eines insbesondere (aber nicht ausschließlich) für den hier betrachteten Zweck geeigneten Strommeßmoduls ist in Fig. 3 dargestellt, wobei Fig. 3A die Oberseite des Moduls, Fig. 3B die Unterseite einer Leiterplatte des Moduls und Fig. 3C eine Seitenansicht zeigen, jeweils ohne ein die Bestandteile des Moduls einkapselndes Gehäuse.

Der in Fig. 3A von oben und in Fig. 3C von der Seite gesehene Präzisionsmesswiderstand 30 ist insgesamt plattenförmig und in bekannter Weise aus einem Widerstandselement 31 aus einer metallischen Legierung vorzugsweise auf Kupferbasis gebildet, beispielsweise auf Basis CuMnNi wie namentlich CuMn12Ni, an dessen einander gegenüberliegende Kanten die Kanten ebenfalls plattenförmiger Stromanschlußteile 32 vorzugsweise aus Kupfer angeschweißt sind. Die Schweißverbindung kann zweckmäßig durch Elektronenstrahlschweißen realisiert sein.

Unmittelbar angrenzend an die jeweilige Schweißnaht befinden sich auf den Oberflächen der Anschlußteile 32 Lötverbindungspads 33, mit denen zweckmäßig vergoldete oder verzinnte Lötflächen 35 (Fig. 3B) an der Unterseite einer unmittelbar über dem Widerstandselement 31 angeordneten Leiterplatte 36 verlötet sind. Bis auf die Lötflächen 35 kann die Unterseite der Leiterplatte 36 mit einem Lötstoplack bedeckt sein. Die Lötflächen 35 sind über Durchkontaktierungen 37 mit Leiterflächen 38 (Fig. 3A) auf der Oberseite der Leiterplatte verbunden. Die Leiterplatte kann in bekannter Weise aus einem wärmeleitenden Isoliermaterial bestehen.

Etwa in der Mitte zwischen den seitlichen Rändern der Leiterplatte 36 und somit auch in bzw. über dem Zentrum des Widerstandselements 31 ist auf der Oberseite der Leiterplatte 36 beispielsweise mit einer wärmeleitenden Klebefolie ein Halbleiterchip 23 montiert, das über Bonddrähte 39 mit den Leiterflächen 38 und somit dem Widerstand 30 elektrisch verbundene Anschlüsse hat. Aufgrund der beschriebenen Anordnung und Verbindungen wird also dem Halbleiter die direkt an den Übergangsstellen zwischen dem Widerstandselement 31 und seinen Kupfer-Stromanschlußteilen 32 abgegriffene Spannung zugeführt, die entsprechend der üblichen 4-Leiter-Messung durch den durch die Stromanschlußteile und das Widerstandselement 31 fließenden Strom erzeugt wird. Die dafür erforderlichen Stromanschlüsse der Anschlußteile 32 sind nicht dargestellt. Der Anschluß kann beispielsweise direkt an einem Hauptstromkabel oder über Stromschienen an einer Batterie erfolgen. Ein genereller Vorteil der beschriebenen Bauform ist aber die problemlose Anpassung der Stromanschlüsse an den jeweiligen Anwendungsfall.

Weitere Anschlüsse des Halbleiterchips 23 sind über Leiterbahnen 40 der Leiterplatte 36 mit einem Stecker 41 verbunden, der z.B. zwei Stifte für die Meßdatenübertragung und zwei weitere Stifte für die Spannungsversorgung des Halbleiterchips 23 haben und zur Verbindung mit dem genormten Datenbus CAN ausgebildet sein kann. Durch diese Verbindung kann die Meßspannung des Widerstands auf den Massepol des Datenbus CAN bezogen sein. Der Stecker 41 kann wie das Halbleiterchip 23 auf die Leiterplatte 36 geklebt sein.

Das beschriebene Strommeßmodul zeichnet sich aus durch kleines Bauvolumen, minimale Störspannungen aufgrund extrem kurzer Verbindungsleitungen, optimale Temperaturkompensationsmöglichkeit sowie die Möglichkeit sehr geringen Gesamtwiderstands und entsprechend geringer Verlustleistung und kann mit wenig Aufwand und entsprechend kostengünstig hergestellt werden. Zur Herstellung der in Fig. 3 dargestellten Bauform kann zunächst die Leiterplatte 36 vollständig vorgefertigt und mit allen Komponenten bestückt werden. Hierbei ist alternativ zu der elektrischen Verbindung des Halbleiters mit der Leiterplatte 36 durch Bonddrähte 39 auch eine sogenannte BGA-Ausführung (Ball-Grid-Array) möglich, bei der die Kontaktierung durch ein Reflow-Lötverfahren bewirkt wird. Anschließend wird die Leiterplatte 36 zweckmäßig im Reflow-Verfahren mit dem Präzisionsmesswiderstand 30 verlötet, wobei die vorverzinnten oder vergoldeten Lötflächen an der Unterseite der Leiterplatte mit den Kupferflächen des Widerstands verbunden werden, so daß sich die in Fig. 3C dargestellte Anordnung ergibt.

Der gesamte Bereich um das aktive Widerstandselement 31 mit dem darauf befindlichen Halbleiterchip 23 und dem Stecker 41 und ggf. der Leiterplatte 36 kann nach der Montage zur Bildung eines Gehäuses mit einem Kunststoff, z.B. Duroplast umhüllt werden, so daß sich ein kompaktes, mechanisch stabiles Bauteil mit zwei Stromanschlüssen an den freistehenden Anschlußteilen 32 und dem Stecker 41 ergibt.

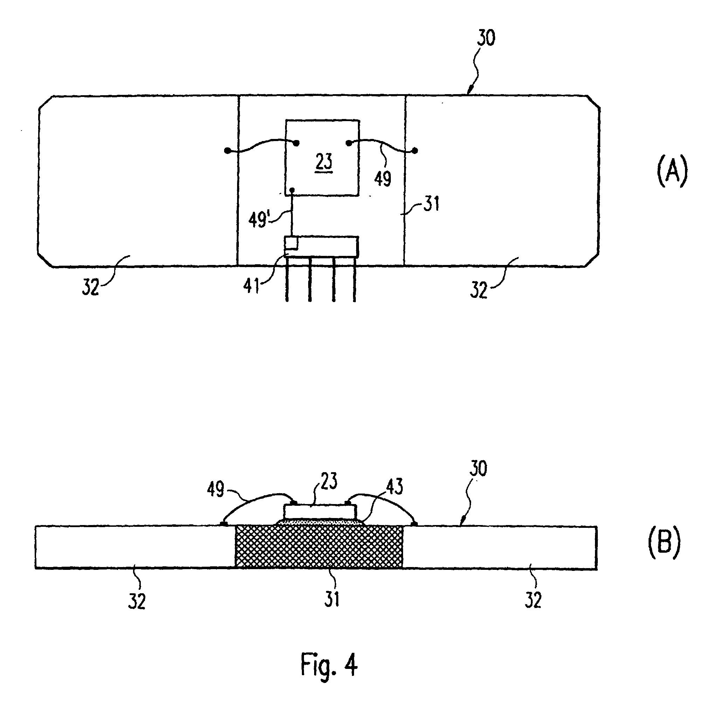

In Fig. 4 ist eine andere bevorzugte Ausführungsform des Strommeßmoduls dargestellt, wobei Fig. 4A eine Draufsicht von oben und Fig. 4B eine Seitenansicht zeigen, jeweils wieder ohne Gehäuse oder Einkapselung. Das Modul kann denselben Präzisionsmesswiderstand 30 und dasselbe Halbleiterchip 23 enthalten und ebenfalls beispielsweise mit einem CAN-Stecker 41 versehen sein, wie die Ausführungsform nach Fig. 3. Das Halbleiterchip 23 ist hier aber mit einem elektrisch isolierenden, thermisch dagegen gut leitenden Kleber 43, beispielsweise einer Klebefolie, unmittelbar auf die metallische Oberfläche des Widerstandselement 31 geklebt, darstellungsgemäß etwa in die Mitte der ersichtlich größeren Widerstandsfläche. Auch der Stecker 41 ist hier auf den Widerstand geklebt. Bonddrähte 49 bzw. 49' bilden die elektrischen Verbindungen des Halbleiterchips 23 mit den Stromanschlußteilen 32, vorzugsweise wieder in unmittelbarer Nähe der Übergangsstellen zwischen Legierung und Kupfer, bzw. mit dem Stecker 41. Ein Vorteil dieser Ausführungsform ist die besonders gute thermische Kopplung zwischen Halbleiter und Widerstand und der besonders geringe und kostengünstige Herstellungaufwand.

Das Halbleiterchip 23 kann als ASIC (application - specific integrated circuit) auf kleinstem Raum (wenige mm Chipkantenlänge) u.a. die gesamte zur Strommessung erforderliche Auswerteund Signalübertragungselektronik mit Verstärkerschaltung, A/D-Wandler und Mikroprozessor enthalten. Darüber hinaus enthält es einen speziellen, in an sich bekannter Weise als Halbleiterelement (Transistor) gebildeten Temperatursensor, der aufgrund der beschriebenen Wärmekopplung permanent die Temperatur des Widerstandselements 31 mißt, und aus dessen Meßinformation beispielsweise der vorhandene, hier als Temperaturkompensationsschaltung dienende Prozessor Korrekturdaten für die Strommeßsignale errechnet. Durch diese Kompensation des an sich geringen Einflusses des Temperaturkoeffizienten (TK) des Widerstands wird höchstmögliche Meßgenauigkeit des aufgrund seines Legierungstyps ohnehin sehr präzisen Widerstands erreicht.

Das Halbleiterchip 23 kann ferner einen besonderen Permanentspeicher beispielsweise vom Typ EEPROM enthalten, der für die Kalibrierung des Meßwiderstands verwendet wird. Hierbei wird zunächst nach der Herstellung des Präzisionsmesswiderstands 30 dessen tatsächlicher Wert ggf. temperaturabhängig gemessen und digital gespeichert. Später wird dann nach der Montage des Widerstands im Strommeßmodul und eventuell erst nach dessen Einbau in das Stromversorgungssystem z.B. gemäß Fig. 1 der tatsächliche Widerstandswert als Kalibrierungsdaten zweckmäßig über den Steuerbus CAN in das Halbleiterchip 23 übertragen und dort permanent gespeichert. Mit den gespeicherten Kalibrierungsdaten wird beim Stromüberwachungsbetrieb kontinuierlich die an den Widerstand angeschlossene Meßschaltung zur Erzeugung korrigierter Meßdaten gesteuert. Der sonst bei Meßwiderständen erforderliche Kalibrierungsaufwand entfällt.

Ein praktisch realisiertes Strommeßmodul der beschriebenen Art mit einem Widerstandswert in der Größenordnung von 0,1-0,5 mOhm ist in der Lage, kurzfristige Ströme bis 500 A und Dauerströme bis 200 A zu messen. Die Meßauflösung kann 14 bis 16 bit betragen, die Meßrate > 1kHz entsprechend einer Meßzeit < 1msec. Das Strommeßmodul ist im gesamten Versorgungsspannungsbereich einsetzbar und problemlos in vorhandene Steuermodule etwa eines Kraftfahrzeugs wie z.B. Regler und Sicherheitsabschalter integrierbar.

## Patentansprüche

1. Einrichtung zur Stromüberwachung in einem Stromversorgungssystem, in dem mehrere Verbraucher (10, 11, 12) über einen ihnen gemeinsamen Leistungsbus (LB) mit Strom versorgt werden und ein Steuerbus (CAN) für digitale Steuerdaten mehrere elektronische Steuereinheiten (µC1, µC2...µCn) untereinander und mit den Verbrauchern verbindet,
mit einem Präzisionsmesswiderstand (30) zur Messung des zu den Verbrauchern (10, 11, 12) fließenden Gesamtstroms und einem permanent elektrisch mit den Spannungsanschlüssen des Präzisionsmesswiderstands verbundenen Halbleiterbauelement (23), das eine Messschaltung zur Erzeugung von digitalen Strommeßsignalen enthält,
wobei,
der Präzisionsmesswiderstand (30) aus einem aus einer Metallegierung bestehenden Widerstandselement (31) gebildet ist und das Halbleiterbauelement (23) in wärmeleitender Verbindung auf einer ebenen Oberfläche des Widerstandselements (31) und/oder seiner Stromanschlussteile (32) angeordnet ist.

2. Einrichtung nach Anspruch 1, **dadurch gekennzeichnet,**
**dass** das Halbleiterbauelement (23) einen Temperatursensor enthält, und dass eine in dem Halbleiterbauelement (23) vorgesehene Temperaturkompensationsschaltung die Strommesssignale in Abhängigkeit von der mit dem Temperatursensor gemessenen Temperatur des Widerstandselements (31) korrigiert.

3. Einrichtung nach Anspruch 1 oder 2, **dadurch gekennzeichnet, dass** das Halbleiterbauelement (23) auf der einen Hauptoberfläche eines aus einer Widerstandslegierung bestehenden plattenförmigen Widerstandselements (31) angeordnet ist, an dessen einander gegenüberliegende Kanten plattenförmige Stromanschlussteile (32) angeschweißt sind.

4. Einrichtung nach einem der Ansprüche 1 bis 3,
**dadurch gekennzeichnet, dass** das Halbleiterbauelement (23) unmittelbar auf die Metalloberfläche des Widerstandselements (31) geklebt und mit dessen Stromanschlussteilen (32) durch Bonddrähte (49) verbunden ist.

5. Einrichtung nach einem der Ansprüche 1 bis 3,
**dadurch gekennzeichnet, dass** das Halbleiterbauelement (23) auf der einen Seite einer Leiterplatte (36) montiert ist, die mit ihrer entgegengesetzten Seite auf der Metalloberfläche des Präzisionsmesswiderstands (30) angeordnet und mit dessen Stromanschlussteilen (32) verlötet ist.

6. Einrichtung nach einem der Ansprüche 1 bis 5, **dadurch gekennzeichnet, dass** das Halbleiterbauelement (23) einen A/D-Wandler, eine Verstärkerschaltung und/oder einen Mikroprozessor für die Messsignale des Präzisionsmesswiderstands (30) enthält.

7. Einrichtung nach einem der Ansprüche 1 bis 6,
**dadurch gekennzeichnet, dass** ein Steckverbinder (41) zum Anschluss des Halbleiterbauelements (23) an den Steuerbus (CAN) vorgesehen ist.

8. Einrichtung nach Anspruch 7, **dadurch gekennzeichnet, dass** der Steckverbinder (41) ein auf die Metalloberfläche des Präzisionsmesswiderstands (30) oder auf eine zwischen dem Präzisionsmesswiderstand (30) und dem Halbleiterbauelement (23) angeordnete Leiterplatte (36) geklebtes, elektrisch mit dem Halbleiterbauelement (23) verbundenes Bauteil ist.

9. Verwendung der Einrichtung nach einem der Ansprüche 1 bis 8 zum Messen des Gesamtstroms mehrerer Verbraucher (10, 11, 12) oder des Ladestromes oder des Entladestromes einer Batterie in einem Fahrzeug.

## Claims

1. Device for monitoring current in a current supply system, in which a plurality of loads (10, 11, 12) are supplied with current via a common power bus (LB) and a control bus (CAN) for digital control data connects a plurality of electronic control units (µC1, µC2... µCn) to one another and to the loads, with a precision measuring resistor (30) for measuring the total current flowing to the loads (10, 11, 12) and a semiconductor component (23) which is permanently electrically connected to the voltage connections of the precision measuring resistor and contains a measuring circuit for generating digital current measurement signals, wherein the precision measuring resistor (30) is formed from a resistor element (31) made from a metal alloy and the semiconductor component (23) is disposed in heat-conducting connection on a level surface of the resistor element (31) and/or its current connection parts (32).

2. Device as claimed in Claim 1, **characterised in that** the semiconductor element (23) contains a temperature sensor and that a temperature compensation circuit provided in the semiconductor component (23) corrects the current measurement signals as a function of the temperature of the resistor (31) measured by the temperature sensor.

3. Device as claimed in Claim 1 or 2, **characterised in that** the semiconductor component (23) is disposed on one main surface of a plate-shaped resistor element (31) made from a resistor alloy, plate-shaped current connection parts (32) being welded onto the edges of the said resistor element which lie opposite one another.

4. Device as claimed in one of Claims 1 to 3, **characterised in that** the semiconductor component (23) is adhered directly onto the metal surface of the resistor element (31) and is connected to the current connection parts (32) thereof by bonding wires (49).

5. Device as claimed in one of Claims 1 to 3, **characterised in that** the semiconductor component (23) is mounted on one side of a circuit board (36) which is disposed with its opposite side on the metal surface of the precision measuring resistor (30) and is soldered to the current connection parts (32) thereof.

6. Device as claimed in one of Claims 1 to 5, **characterised in that** the semiconductor component (23) contains a A/D converter, an amplifier circuit and/or a microprocessor the measurement signals of the precision measuring resistor (30).

7. Device as claimed in one of Claims 1 to 6, **characterised in that** a plug-type connector (41) is provided for connection of the semiconductor component (23) to the control bus (CAN).

8. Device as claimed in Claim 7, **characterised in that** the plug-type connector (41) is a component which is electrically connected to the semiconductor component (23) and is adhered to the metal surface of the precision measuring resistor (30) or to a circuit board (36) disposed between the precision measuring resistor (30) and the semiconductor component (23).

9. Use of the device as claimed in one of Claims 1 to 8 for measuring the total current of a plurality of loads (10, 11, 12) or the charging current or the discharging current of a battery in a vehicle.

## Revendications

1. Dispositif de surveillance du courant dans un système d'alimentation en courant, dans lequel plusieurs récepteurs (10, 11, 12) sont alimentés en courant par un bus d'alimentation (LB) qui leur est commun, et un bus de commande (CAN) pour données numériques de commande relie plusieurs unités électroniques de commande (µC1, µC2... µCn) entre elles et aux récepteurs, comportant une résistance de mesure de précision (30) pour mesurer le courant total qui s'écoule vers les récepteurs (10, 11, 12) et comportant un composant à semi-conducteurs (23), qui est relié électriquement en permanence aux bornes de tension de la résistance de mesure de précision et qui contient un circuit de mesure pour produire des signaux numériques de mesure du courant, dans lequel la résistance de mesure de précision (30) est formée à partir d'un élément de résistance (31), constitué d'un alliage métallique, et le composant à semi-conducteurs (23) est disposé, dans une liaison conductrice de la chaleur, sur une surface plane de l'élément de résistance (31) et/ou de ses parties de branchement de courant (32).

2. Dispositif selon la revendication 1, **caractérisé en ce que** le composant à semi-conducteurs (23) contient une sonde de température et **en ce qu'**un circuit de compensation de la température, prévu dans le composant à semi-conducteurs (23), corrige les signaux de mesure du courant en fonction de la température de l'élément de résistance (31) mesurée au moyen de la sonde de température.

3. Dispositif selon la revendication 1 ou 2, **caractérisé en ce que** le composant à semi-conducteurs (23) est disposé sur une surface principale d'un élément de résistance (31) en forme de plaque, constitué d'un alliage pour résistance, sur ses bords opposés les uns aux autres étant soudées des parties de branchement de courant (32) en forme de plaque.

4. Dispositif selon l'une des revendications 1 à 3, **caractérisé en ce que** le composant à semi-conducteurs (23) est directement collé sur la surface métallique de l'élément de résistance (31) et est relié, par des fils métalliques de liaison (49), à ses parties de branchement de courant (32).

5. Dispositif selon l'une des revendications 1 à 3, **caractérisé en ce que** le composant à semi-conducteurs (23) est monté sur une face d'une plaquette à circuits imprimés (36) qui, par sa face opposée, est disposée sur la surface métallique de la résistance de mesure de précision (30) et est brasée avec ses parties de branchement de courant (32).

6. Dispositif selon l'une des revendications 1 à 5, **caractérisé en ce que** le composant à semi-conducteurs (23) contient un convertisseur analogique/numérique, un circuit d'amplification et/ou un microprocesseur pour les signaux de mesure de la résistance de mesure de précision (30).

7. Dispositif selon l'une des revendications 1 à 6, **caractérisé en ce qu'**un connecteur à fiches (41) est prévu pour le branchement du composant à semi-conducteurs (23) sur le bus de commande (CAN).

8. Dispositif selon la revendication 7, **caractérisé en ce que** le connecteur à fiches (41) est un composant collé sur la surface métallique de la résistance de mesure de précision (30) ou sur une plaquette à circuits imprimés (36) disposée entre la résistance de mesure de précision (30) et le composant à semi-conducteurs (23), et reliée électriquement au composant à semi-conducteurs (23).

9. Utilisation du dispositif selon l'une des revendications 1 à 8 pour mesurer le courant total de plusieurs récepteurs (10, 11, 12) ou le courant de charge ou le courant de décharge d'une batterie d'un véhicule.
